# DEMANDE DE BREVET EUROPEEN

(11) **EP 4 408 130 A1**
(43) Date de publication de la demande: **31.07.2024**
(21) Numéro de dépôt: 23305108.5
(22) Date de dépôt: 27.01.2023
(51) Int. Cl.: H05K 1/02, H05K 1/16, H05K 1/18

(54) **CIRCUIT ELECTRONIQUE ET PROCEDE DE PROTECTION CORRESPONDANT**

(71) Demandeur: BULL SAS, 78340 Les Clayes-Sous-Bois (FR)
(72) Inventeur: DUCLOYER, Sylvain, 78650 BEYNES (FR); COULON, Nicolas, 78350 JOUY-EN-JOSAS (FR); DOUARD, Yannick, 78370 PLAISIR (FR)
(74) Mandataire: IPAZ

(57) **Abrégé**

L'invention concerne un circuit électronique comprenant un substrat et au moins un composant électronique (3, 6),
chaque composant électronique (3, 6) comportant au moins un port de données (12) pour la réception de données,
le circuit électronique (2) comprenant, en outre, pour chaque port de données (12) :
- une borne (8) d'injection de courant ;
- une piste électrique sécable (10) située dans l'épaisseur du substrat et s'étendant entre le port de données (12) et la borne d'injection (8),

chaque piste électrique sécable (10) comprenant un segment fusible (20) et étant configurée pour se rompre, par fusion du segment fusible (20), lors de l'injection, au niveau de la borne d'injection (8), d'un courant électrique (I) présentant une intensité supérieure à un seuil de rupture de piste prédéterminé.

## Description

La présente invention concerne un circuit électronique comprenant un substrat et au moins un composant électronique, chaque composant électronique comportant au moins un port de données pour la réception de données.

L'invention concerne également un procédé de protection d'un tel circuit électronique contre les intrusions.

L'invention s'applique au domaine de l'électronique, et en particulier à la conception de circuits électroniques comportant au moins un composant électronique, tel qu'un composant programmable.

### État de la technique

Il est connu de munir un circuit électronique d'un ou de plusieurs composant(s) programmable(s), par exemple un FPGA (de l'anglais « *Field-Programmable Gate Array »,* ou réseau de portes programmables *in situ*). De façon classique, un tel composant programmable comporte au moins un port de données pour l'écriture d'instructions relatives à sa configuration.

Lors de la phase de production du circuit électronique, et après intégration du composant programmable dans ledit circuit, la configuration du composant programmable est généralement mise en oeuvre par l'application de signaux électriques (codant lesdites instructions) au niveau d'une sonde, elle-même électriquement reliée à chaque port de données par le biais d'un bus.

Pour des raisons de sécurité, notamment pour protéger le composant programmable contre des intrusions visant à le reprogrammer ou à en lire le contenu, un tel bus doit être rendu inopérant. Il est notamment connu de casser le coupon du bus (c'est-à-dire la zone du circuit électronique sur laquelle est gravé le bus) pour le rendre inopérant.

Néanmoins, un tel procédé ne donne pas entière satisfaction.

En effet, malgré une telle cassure, les parties restantes du bus sont exposées et sont donc accessibles. Il est alors possible de reconstituer la liaison de données en analysant ces parties exposées afin de les reconnecter. Par conséquent, une simple cassure du coupon du bus n'est pas suffisante pour assurer un niveau de sécurité satisfaisant.

Un but de la présente invention est donc de remédier à au moins un des inconvénients de l'état de la technique.

Un autre but de l'invention est de proposer un circuit électronique dans lequel il soit plus difficile d'accéder aux ports de données d'un composant programmable - et, de façon plus générale, d'un composant électronique - qu'il comprend, à l'issue d'une rupture du bus entre la sonde et ledit composant électronique.

### Exposé de l'invention

À cet effet, l'invention a pour objet un circuit électronique du type précité, comprenant, en outre, pour chaque port de données :
- une borne d'injection de courant ;
- une piste électrique sécable située dans l'épaisseur du substrat et s'étendant entre le port de données et la borne d'injection,
chaque piste électrique sécable comprenant un segment fusible et étant configurée pour se rompre, par fusion du segment fusible, lors de l'injection, au niveau de la borne d'injection, d'un courant électrique présentant une intensité supérieure à un seuil de rupture de piste prédéterminé.

En effet, la piste électrique sécable étant enterrée dans le substrat du circuit électronique, la rupture du segment fusible a pour effet d'isoler physiquement le port de données (ou, plus précisément, la partie de la piste électrique sécable située entre le port de données et le segment fusible) vis-à-vis de l'extérieur. Par conséquent, une intrusion visant à accéder au port de données est fortement compromise, dans la mesure où elle nécessiterait de détériorer le substrat pour accéder à la piste électrique rompue, avec un risque non négligeable d'endommager le circuit électronique de façon irréversible.

Suivant d'autres aspect avantageux de l'invention, le circuit électronique comprend une ou plusieurs des caractéristiques suivantes, prise(s) isolément ou suivant toutes les combinaisons techniquement possibles :
chaque piste électrique sécable comprend, en outre, un premier segment conducteur connecté entre le segment fusible et la borne d'injection ;
le segment fusible présente une résistance électrique linéique supérieure à une résistance électrique linéique du premier segment conducteur ;
le segment fusible présente une résistance thermique supérieure à une résistance thermique du premier segment conducteur ;
le segment fusible présente une section inférieure à une section du premier segment conducteur ;
chaque piste électrique sécable comprend, en outre, un deuxième segment conducteur connecté entre le segment fusible et le port de données ;
le circuit électronique comprend, en outre, pour chaque port de données, une borne de sortie de courant pour la connexion à une référence de potentiel ;
chaque composant électronique est connecté à la borne de sortie de courant ;
chaque piste électrique sécable comprend, en outre, un segment conducteur auxiliaire situé dans l'épaisseur du substrat et connecté entre le segment fusible correspondant et la borne de sortie de courant ;
pour au moins un port de données :
   - le premier segment conducteur et le segment conducteur auxiliaire de la piste électrique sécable correspondante s'étendent suivant un même premier axe ; et
   - le deuxième segment conducteur de la piste électrique sécable correspondante s'étend suivant un deuxième axe non parallèle, de préférence perpendiculaire, au premier axe ;
pour au moins un port de données :
   - le premier segment conducteur, le deuxième segment conducteur et le segment conducteur auxiliaire de la piste électrique sécable correspondante s'étendent suivant des axes parallèles ; et
   - la borne de sortie de courant est plus proche de la borne d'injection que dudit port de données ;
pour chaque port de données, au moins un parmi le premier segment conducteur et le segment conducteur auxiliaire de la piste électrique sécable correspondante comprend une première partie et une deuxième partie plus proche du segment fusible que la première partie, une largeur de la deuxième partie étant supérieure à une largeur de la première partie pour former un dissipateur thermique.

En outre, l'invention a pour objet un procédé de protection d'un composant électronique compris dans un circuit électronique tel que défini ci-dessus, le procédé comprenant, pour chaque port de données, les étapes :
- connexion de la borne d'injection à une source de courant ; et
- injection, au niveau de la borne d'injection, d'un courant électrique présentant une intensité supérieure au seuil de rupture de piste prédéterminé.

Suivant un autre aspect avantageux de l'invention, le procédé de protection comprend la caractéristique suivante :
le composant électronique est configuré de sorte que, lorsqu'une première polarisation lui est appliquée, chaque port de données présente un état haute impédance, le procédé comprenant, pour chaque port de données, préalablement à l'étape d'injection, les étapes suivantes :
- première polarisation du composant électronique de façon à ce que le port de données soit dans l'état haute impédance ; et
- connexion de la borne de sortie de courant à la source de courant pour autoriser la circulation de courant électrique entre la borne d'injection et la borne de sortie de courant à travers la piste électrique sécable correspondante.

### Brève description des dessins

L'invention sera mieux comprise à la lecture de la description qui va suivre, donnée uniquement à titre d'exemple non limitatif et faite en se référant aux dessins annexés sur lesquels :
la figure 1 est une vue en section d'un premier mode de réalisation d'un circuit électronique selon l'invention, dans un plan orthogonal à un substrat du circuit ;
la figure 2 est une représentation schématique du circuit électronique de la figure 1, lors de la mise en oeuvre du procédé de protection selon l'invention ;
la figure 3 est une représentation analogue à la figure 2, après la mise en oeuvre du procédé de protection ;
la figure 4 est une représentation schématique d'un deuxième mode de réalisation d'un circuit électronique selon l'invention, lors de la mise en oeuvre du procédé de protection selon l'invention ;
la figure 5 est une représentation analogue à la figure 4, après la mise en oeuvre du procédé de protection ;
la figure 6 est une représentation schématique, dans un plan parallèle au substrat, d'une première variante d'une piste électrique sécable du circuit électronique de la figure 4 ;
la figure 7 est une représentation schématique, dans un plan parallèle au substrat, d'une deuxième variante de la piste électrique sécable du circuit électronique de la figure 4 ; et
la figure 8 est une représentation schématique, dans un plan parallèle au substrat, d'une troisième variante de la piste électrique sécable du circuit électronique de la figure 4.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si c'est cette partie qui est uniquement suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures et dans la suite de la description, les éléments communs à plusieurs figures conservent la même référence.

### Description détaillée

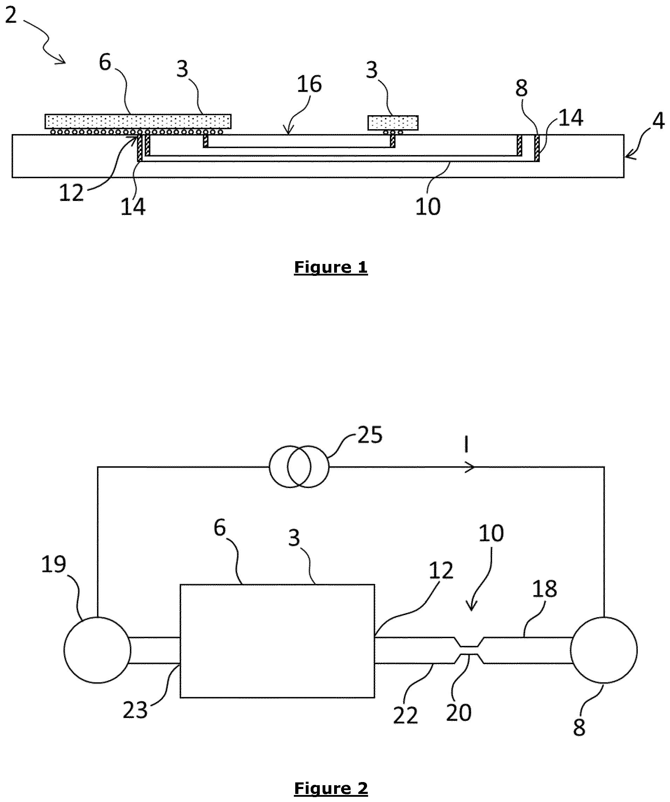

Un circuit électronique 2 selon l'invention est illustré par la figure 1.

Comme cela apparaît sur cette figure, le circuit électronique 2 comprend un substrat 4, sur lequel est agencé au moins un composant électronique 3.

Le circuit électronique 2 comporte, en outre, au moins une borne 8 d'injection de courant (appelée « borne d'injection » par la suite), et au moins une piste électrique sécable 10.

Le composant électronique 3 est, par exemple, un composant programmable 6. En variante, le composant électronique 3 n'est pas un composant programmable ; dans ce cas, le composant électronique 3 est, par exemple, une interface, telle qu'un connecteur.

Dans le cas où le composant électronique 3 est un composant programmable 6, ledit composant programmable 6 appartient, par exemple, à la famille des circuits logiques programmables (« *Programmable Logical Device* » en anglais, ou PLD), tel qu'un réseau de portes programmables *in situ* (« *Field-Programmable Gate Array* » en anglais, ou FPGA). En alternative, le composant programmable 6 est un processeur (« *Central Processing Unit* » en anglais, ou CPU), ou encore un microcontrôleur.

Le composant électronique 3 comporte au moins un port de données 12 pour recevoir des données destinées audit composant électronique 3.

Chaque port de données 12 du composant électronique 3 est associé à une borne d'injection 8 du circuit électronique 2. En particulier, pour chaque port de données 12, la borne d'injection 8 correspondante est destinée à autoriser l'utilisateur à appliquer les données destinées au composant électronique 3 qui ont été mentionnées précédemment.

Plus précisément, chaque port de données 12 est électriquement relié à la borne d'injection 8 correspondante au moyen d'une piste électrique sécable 10 s'étendant entre le port de données 12 et la borne d'injection 8 associée.

En outre, chaque piste électrique sécable 10 est située dans l'épaisseur du substrat 4, de sorte que la piste électrique sécable 10 est physiquement isolée de l'extérieur. Dans ce cas, chaque borne d'injection 8 et chaque port de données 12 est, par exemple, électriquement relié à la piste électrique sécable 10 correspondante au moyen d'un via 14 respectif, s'étendant d'une surface externe 16 du substrat 4 jusqu'à la piste électrique sécable 10.

Dans le cas où le composant électronique 3 est un composant programmable 6, comme illustré par la figure 1, le port de données 12 est, notamment, destiné à la configuration dudit composant programmable 6. En particulier, chaque port de données 12 est destiné à autoriser un utilisateur à écrire, dans le composant programmable 6, des instructions relatives à la configuration du composant programmable 6. Dans ce cas, la borne d'injection 8 correspondante est destinée à autoriser l'utilisateur à appliquer des instructions relatives à la configuration du composant programmable 6.

Comme illustré par la figure 2, chaque piste électrique sécable 10 comprend un premier segment conducteur 18, un segment fusible 20 et un deuxième segment conducteur 22, agencés dans cet ordre entre la borne d'injection 8 et le port de données 12.

Le premier segment conducteur 18, le segment fusible 20 et le deuxième segment conducteur 22 sont chacun réalisés dans un matériau conducteur, de façon à assurer la continuité électrique entre la borne d'injection 8 et le port de données 12, tant que ladite continuité électrique est souhaitée.

La piste électrique sécable 10 est, en outre, configurée pour se rompre, par fusion du segment fusible 20 correspondant, lors de l'injection, au niveau de la borne d'injection 8, d'un courant électrique I présentant une intensité supérieure à un seuil de rupture de piste prédéterminé.

Le seuil de rupture de piste est, de préférence, compris entre 0,5 A (ampère) et 2 A, par exemple entre 0,75 A et 1,25 A, pour une piste électrique sécable 10 présentant une section entre 2,7 et 4,5 mm² au niveau du premier segment conducteur 18, et une section entre 1,8 et 2,7 mm² au niveau du segment fusible 20.

De préférence, le segment fusible 20 présente une résistance électrique linéique supérieure à la résistance électrique linéique du premier segment conducteur 18. Dans ce cas, la circulation du courant électrique I le long de la piste électrique sécable 10 entraîne son échauffement par effet Joule, et en particulier un échauffement local plus important au niveau du segment fusible 20. Si le courant électrique I présente une intensité supérieure au seuil de rupture de piste prédéterminé, l'échauffement local du segment fusible 20 entraîne sa fusion, et donc la rupture de la piste électrique sécable 10.

Alternativement, ou de façon additionnelle, le segment fusible 20 présente une résistance thermique supérieure à la résistance thermique du premier segment conducteur 18. Dans ce cas, la circulation du courant électrique I le long de la piste électrique sécable 10 entraîne un échauffement par effet Joule localement plus important au niveau du segment fusible 20. De la même façon que précédemment, si le courant électrique I présente une intensité supérieure au seuil de rupture de piste prédéterminé, l'échauffement local du segment fusible 20 entraîne sa fusion, et donc la rupture de la piste électrique sécable 10.

Par exemple, une plus grande résistance électrique linéique au niveau du segment fusible 20 et/ou une plus grande résistance thermique au niveau du segment fusible 20 sont susceptibles d'être atteintes en concevant une piste électrique sécable 10 dans laquelle le segment fusible 20 présente une section inférieure à une section du premier segment conducteur 18, de sorte à former un étranglement, ou un resserrement, au niveau du segment fusible 20.

Par « section », il est entendu, au sens de la présente invention, une section transversale, c'est-à-dire dans un plan orthogonal à une direction suivant laquelle s'étend localement la piste électrique sécable 10.

Alternativement, ou de façon complémentaire, une plus grande résistance électrique linéique au niveau du segment fusible 20 et/ou une plus grande résistance thermique au niveau du segment fusible 20 sont susceptibles d'être atteintes en concevant une piste électrique sécable 10 dans laquelle le segment fusible 20 est réalisé dans un matériau conducteur différent de celui dans lequel sont réalisés le premier segment conducteur 18 et le deuxième segment conducteur 22.

De préférence, le circuit électronique 2 comprend, en outre, une borne de sortie de courant 19 (dite « borne de sortie 19 »), destinée à être reliée à une référence de potentiel électrique, par exemple pour une mise à la masse du circuit électronique 2.

Dans ce cas, le composant électronique 3 est, de préférence, également connecté à la borne de sortie 19, par exemple via un port de sortie 23.

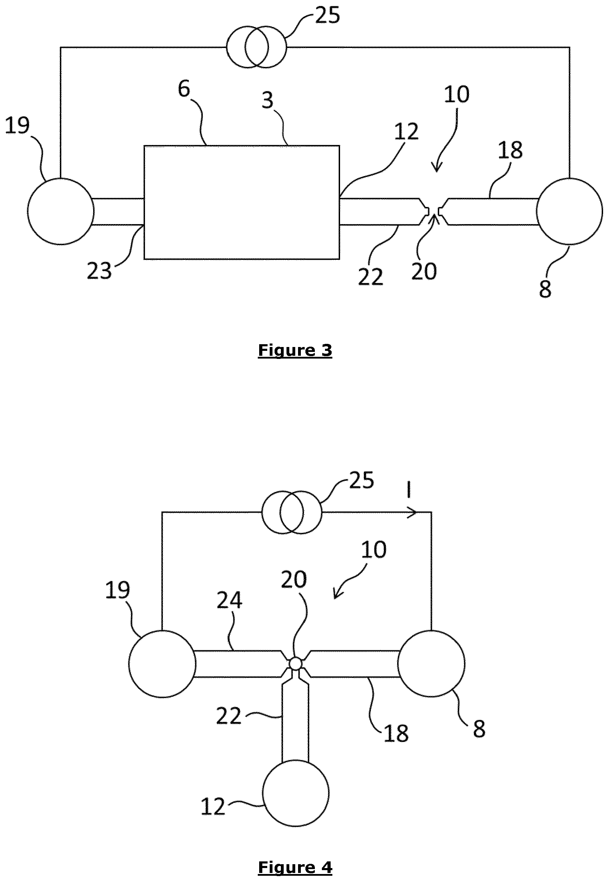

La déconnexion du composant électronique 3, en vue de le protéger contre les intrusions, va maintenant être décrite en référence aux figures 2 et 3.

Lorsque la déconnexion du composant électronique 3 est souhaitée (par exemple, s'il s'agit d'un composant programmable 6, lorsque la programmation dudit composant programmable 6 est achevée), pour chaque port de données 12, la borne d'injection 8 correspondante est connectée à une source de courant 25, comme illustré par la figure 2.

De préférence, le composant électronique 3 est également connecté à la borne de sortie 19, qui est elle-même reliée à la source de courant 25.

Puis, la source de courant 25 est mise en marche de façon à injecter, au niveau de la borne d'injection 8, un courant électrique I présentant une intensité supérieure au seuil de rupture de piste associé à la piste électrique sécable 10 correspondante.

Il en résulte la fusion du segment fusible 20 et donc la section de la piste électrique sécable 10, comme illustré par la figure 3. Un accès au port de données 12 du composant électronique 3 n'est alors plus possible.

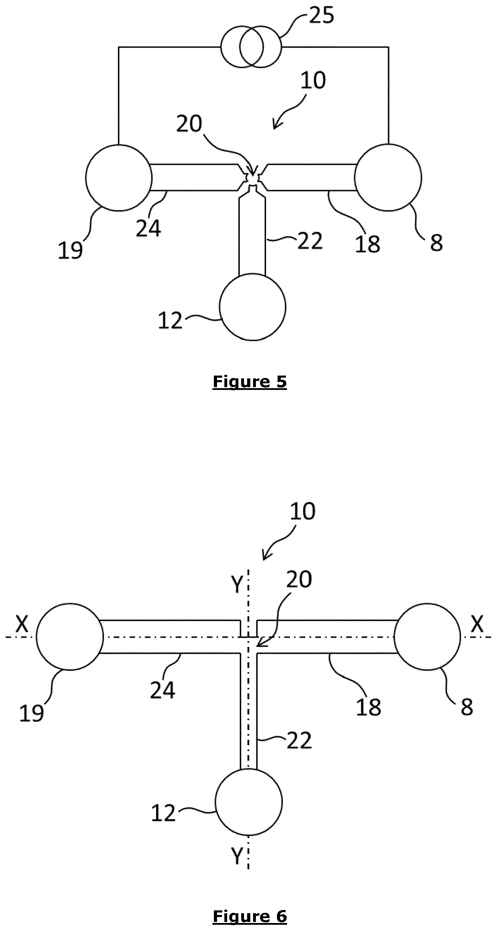

Un autre mode de réalisation est illustré par les figures 4 et 5. Ce mode de réalisation correspond, notamment, à une situation dans laquelle le composant électronique 3 (non représenté) est configuré de sorte que, lorsqu'une polarisation prédéterminée (dite « première polarisation ») est appliquée audit composant électronique 3, chaque port de données 12 se trouve dans un état haute impédance. Cette caractéristique est notamment présente dans certains composants programmables 6.

Le circuit électronique 2 de la figure 4 diffère du circuit électronique de la figure 2 uniquement en ce que, pour chaque port de données 12, la piste électrique sécable 10 comprend également un segment conducteur auxiliaire 24.

À l'instar du premier segment conducteur 18, du segment fusible 20 et du deuxième segment conducteur 22 de la piste électrique sécable 10 correspondante, chaque segment conducteur auxiliaire 24 est également situé dans l'épaisseur du substrat 4.

En outre, pour chaque port de données 12, le segment conducteur auxiliaire 24 associé est électriquement connecté entre la borne de sortie 19 et le segment fusible 20 de la piste électrique sécable 10 correspondante.

La déconnexion du composant électronique 3, en vue de le protéger contre les intrusions, va maintenant être décrite en référence aux figures 4 et 5.

Lorsque la déconnexion du composant électronique 3 est requise (par exemple, s'il s'agit d'un composant programmable, lorsque la programmation dudit composant programmable 6 est achevée), la première polarisation est appliquée au composant électronique 3 de sorte que chaque port de données 12 soit dans son état haute impédance.

En outre, pour chaque port de données 12, la borne d'injection 8 correspondante est connectée à la source de courant 25. La borne de sortie 19 est également connectée à la source de courant 25, pour autoriser la circulation de courant électrique entre la borne d'injection 8 et la borne de sortie 19 à travers la piste électrique sécable 10 correspondante, notamment à travers le premier segment conducteur 18, le segment fusible 20 et le segment conducteur auxiliaire 24 correspondants.

Puis, la source de courant 25 est mise en marche de façon à faire circuler un courant électrique I entre la borne d'injection 8 et la borne de sortie 19.

Le port de données 12 étant dans un état haute impédance, le courant électrique injecté au niveau de la borne d'injection 8 ne peut pas entrer dans le composant électronique 3 par le port de données 12, ce qui empêche une éventuelle dégradation du composant électronique 3.

Si le courant électrique I présente une intensité supérieure au seuil de rupture de piste associé à la piste électrique sécable 10 correspondante, le segment fusible 20 fond, et la piste électrique sécable 10 se retrouve sectionnée, comme illustré par la figure 5. Un accès au port de données 12 du composant électronique 3 n'est alors plus possible.

Le mode de réalisation des figures 4 et 5 a ceci d'avantageux que le courant électrique appliqué pour rompre le segment fusible 20 ne circule pas dans le deuxième segment conducteur 22 (et n'atteint donc pas le composant électronique 3), le port de données 12 étant dans son état haute impédance. Une altération non maîtrisée du composant électronique 3, due au courant électrique I injecté et susceptible de survenir dans le mode de réalisation des figures 2 et 3, est ainsi évitée.

Les figures 6 à 8 illustrent divers agencements possibles de la piste électrique sécable 10.

Par exemple, une géométrie dite « en T » est représentée sur la figure 6.

Dans ce cas, le premier segment conducteur 18 et le segment conducteur auxiliaire 24 de la piste électrique sécable 10 s'étendent suivant un même premier axe X-X.

En outre, le deuxième segment conducteur 22 de la piste électrique sécable 10 s'étend suivant un deuxième axe Y-Y non parallèle au premier axe X-X. De préférence, le deuxième axe Y-Y est perpendiculaire au premier axe X-X.

Une telle géométrie est avantageuse, dans la mesure où elle limite l'impact de la chaleur générée sur les autres conducteurs du circuit électronique 2.

De préférence, la zone de jonction entre le premier segment conducteur 18, le segment conducteur auxiliaire 24 et le deuxième segment conducteur 22 comporte un renfoncement définissant le segment fusible 20.

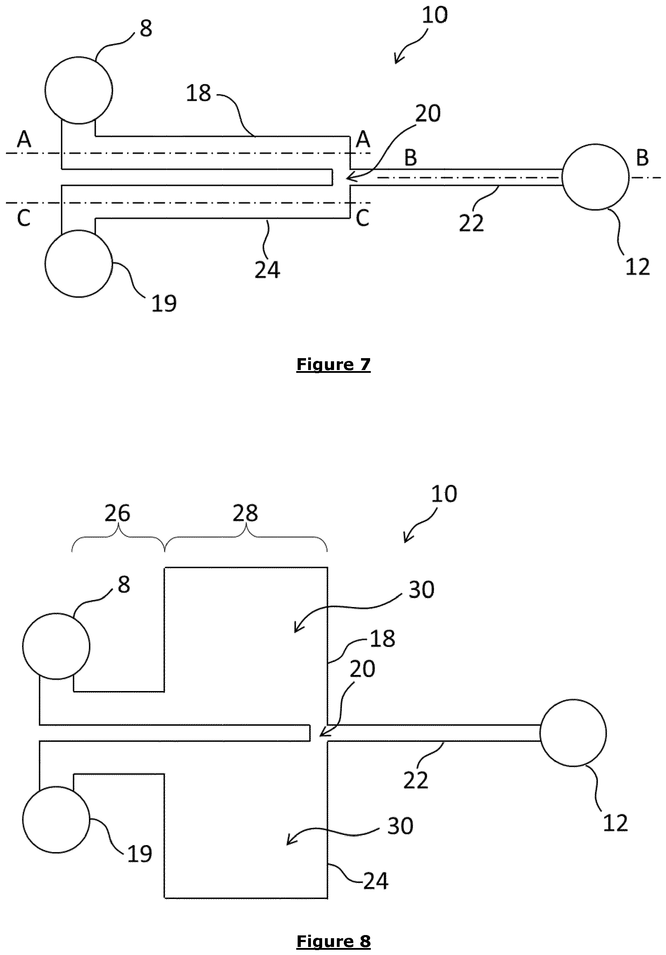

Selon un autre exemple, une géométrie linéaire est représentée sur la figure 7.

Dans ce cas, le premier segment conducteur 18, le deuxième segment conducteur 22 et le segment conducteur auxiliaire 24 de la piste électrique sécable 10 s'étendent suivant des axes parallèles, respectivement A-A, B-B et C-C.

Plus précisément, l'axe B-B s'étend entre les axes A-A et C-C.

En outre, la borne de sortie 19 est plus proche de la borne d'injection 8 que du port de données 12 relié au deuxième segment conducteur 22. En d'autres termes, la borne d'injection 8 et la borne de sortie 19 sont disposées d'un même côté par rapport au segment fusible 20.

Une telle géométrie est avantageuse, dans la mesure où elle limite l'encombrement.

De préférence, le deuxième segment conducteur 22 est décalé suivant l'axe B-B de sorte que la zone de jonction entre le premier segment conducteur 18, le deuxième segment conducteur 22 et le segment conducteur auxiliaire 24 présente des dimensions favorables à un échauffement local supérieur à celui du premier segment conducteur 18 et du segment conducteur auxiliaire 24, définissant ainsi le segment fusible 20.

Alternativement, une géométrie dite « à ailettes » est représentée sur la figure 8. Une telle géométrie est susceptible d'être combinée avec l'une ou l'autre de la géométrie en T (figure 6) et de la géométrie linéaire (figure 7).

Dans ce cas, au moins l'un parmi le premier segment conducteur 18 et le segment conducteur auxiliaire 24 comprend une première partie 26 et une deuxième partie 28. La deuxième partie 28 est plus proche du segment fusible 20 que la première partie 26.

En outre, la deuxième partie 28 présente une largeur supérieure à une largeur de la première partie 26, pour former un dissipateur thermique 30, encore appelée « ailette ».

Par « largeur d'une piste électrique », il est entendu, au sens de la présente invention, la dimension, dans le plan du substrat 4, qui est orthogonale à l'axe de ladite piste électrique.

Une telle géométrie est avantageuse, dans la mesure où les ailettes 30 accentuent la dissipation de chaleur dans le premier segment conducteur 18 et/ou dans le segment conducteur auxiliaire 24, au voisinage du segment fusible 20, ce qui a pour effet de concentrer la chaleur dans le segment fusible 20.

La caractéristique selon laquelle le segment fusible 20 présente une résistance électrique linéique supérieure et/ou une résistance thermique supérieure et/ou une section inférieure à celle du premier segment conducteur 18 est avantageuse, dans la mesure où elle favorise un échauffement local plus important au niveau du segment fusible 20 lors de la circulation du courant électrique I le long de la piste électrique sécable 10.

La présence du segment conducteur auxiliaire 24 est avantageuse, dans la mesure où, lorsque le port de données 12 du composant électronique 3 est apte à présenter un état haute impédance, elle résulte en ce que le courant électrique appliqué pour rompre le segment fusible 20 ne circule pas dans le deuxième segment conducteur 22 lorsque ledit port de données 12 est dans son état haute impédance, et n'atteint donc pas le composant électronique 3. De cette façon, une altération non maîtrisée du composant électronique 3, due au courant électrique I injecté pour dégrader le segment fusible 20, est évitée.

La géométrie en T est avantageuse, dans la mesure où elle limite l'impact de la chaleur générée sur les autres conducteurs du circuit électronique 2.

La géométrie linéaire est avantageuse, dans la mesure où elle limite l'encombrement.

La présence d'ailettes 30 est avantageuse, dans la mesure où lesdites ailettes 30 accentuent la dissipation de chaleur dans le premier segment conducteur 18 et/ou dans le segment conducteur auxiliaire 24, au voisinage du segment fusible 20, ce qui a pour effet de concentrer la chaleur dans le segment fusible 20.

## Revendications

1. Circuit électronique (2) comprenant un substrat (4) et au moins un composant électronique (3, 6),
chaque composant électronique (3, 6) comportant au moins un port de données (12) pour la réception de données,
le circuit électronique (2) comprenant, en outre, pour chaque port de données (12) :
- une borne (8) d'injection de courant ;
- une piste électrique sécable (10) située dans l'épaisseur du substrat (4) et s'étendant entre le port de données (12) et la borne d'injection (8),
chaque piste électrique sécable (10) comprenant un segment fusible (20) et étant configurée pour se rompre, par fusion du segment fusible (20), lors de l'injection, au niveau de la borne d'injection (8), d'un courant électrique (I) présentant une intensité supérieure à un seuil de rupture de piste prédéterminé.

2. Circuit électronique (2) selon la revendication 1, dans lequel chaque piste électrique sécable (10) comprend, en outre, un premier segment conducteur (18) connecté entre le segment fusible (20) et la borne d'injection (8).

3. Circuit électronique (2) selon la revendication 2, dans lequel le segment fusible (20) présente une résistance électrique linéique supérieure à une résistance électrique linéique du premier segment conducteur (18).

4. Circuit électronique (2) selon la revendication 2 ou 3, dans lequel le segment fusible (20) présente une résistance thermique supérieure à une résistance thermique du premier segment conducteur (18).

5. Circuit électronique (2) selon l'une quelconque des revendications 2 à 4, dans lequel le segment fusible (20) présente une section inférieure à une section du premier segment conducteur (18).

6. Circuit électronique (2) selon l'une quelconque des revendications 1 à 5, dans lequel chaque piste électrique sécable (10) comprend, en outre, un deuxième segment conducteur (22) connecté entre le segment fusible (20) et le port de données (12).

7. Circuit électronique (2) selon l'une quelconque des revendications 1 à 6, comprenant, en outre, pour chaque port de données (12), une borne de sortie de courant (19) pour la connexion à une référence de potentiel.

8. Circuit électronique (2) selon la revendication 7, dans lequel chaque composant électronique (3, 6) est connecté à la borne de sortie de courant (19).

9. Circuit électronique (2) selon la revendication 7, dans lequel chaque piste électrique sécable (10) comprend, en outre, un segment conducteur auxiliaire (24) situé dans l'épaisseur du substrat (4) et connecté entre le segment fusible (20) correspondant et la borne de sortie de courant (19).

10. Circuit électronique (2) selon l'une quelconque des revendications 2 à 5, la revendication 6 et la revendication 9, dans lequel, pour au moins un port de données (12) :
- le premier segment conducteur (18) et le segment conducteur auxiliaire (24) de la piste électrique sécable (10) correspondante s'étendent suivant un même premier axe (X-X) ; et
- le deuxième segment conducteur (22) de la piste électrique sécable (10) correspondante s'étend suivant un deuxième axe (Y-Y) non parallèle, de préférence perpendiculaire, au premier axe (X-X).

11. Circuit électronique (2) selon l'une quelconque des revendications 2 à 5, la revendication 6 et la revendication 9, dans lequel, pour au moins un port de données (12) :
- le premier segment conducteur (18), le deuxième segment conducteur (22) et le segment conducteur auxiliaire (24) de la piste électrique sécable (10) correspondante s'étendent suivant des axes parallèles (A-A, B-B, C-C) ; et
- la borne de sortie de courant (19) est plus proche de la borne d'injection (8) que dudit port de données (12).

12. Circuit électronique (2) selon l'une quelconque des revendications 2 à 5, la revendication 6 et l'une quelconque des revendications 9 à 11, dans lequel, pour chaque port de données (12), au moins un parmi le premier segment conducteur (18) et le segment conducteur auxiliaire (24) de la piste électrique sécable (10) correspondante comprend une première partie (26) et une deuxième partie (28) plus proche du segment fusible (20) que la première partie (26), une largeur de la deuxième partie (28) étant supérieure à une largeur de la première partie (26) pour former un dissipateur thermique.

13. Procédé de protection d'un composant électronique (3, 6) compris dans un circuit électronique (2) selon l'une quelconque des revendications 1 à 12, le procédé comprenant, pour chaque port de données (12) :
- connexion de la borne d'injection (8) à une source de courant (25) ; et
- injection, au niveau de la borne d'injection (8), d'un courant électrique (I) présentant une intensité supérieure au seuil de rupture de piste prédéterminé.

14. Procédé de protection selon la revendication 13 lorsqu'elle dépend de l'une quelconque des revendications 9 à 12, dans lequel le composant électronique (3, 6) est configuré de sorte que, lorsqu'une première polarisation lui est appliquée, chaque port de données (12) présente un état haute impédance, le procédé comprenant, pour chaque port de données (12), préalablement à l'étape d'injection, les étapes suivantes :
- première polarisation du composant électronique (3, 6) de façon à ce que le port de données (12) soit dans l'état haute impédance ; et
- connexion de la borne de sortie de courant (19) à la source de courant (25) pour autoriser la circulation de courant électrique (I) entre la borne d'injection (8) et la borne de sortie de courant (19) à travers la piste électrique sécable (10) correspondante.
